Europäisches Patentamt

European Patent Office

Office européen des brevets

(19)

(11) Numéro de publication: **0 238 367**

**B1**

(12) **FASCICULE DE BREVET EUROPEEN**

(45) Date de publication du fascicule du brevet: **01.08.90**

(21) Numéro de dépôt: **87400146.4**

(22) Date de dépôt: **22.01.87**

(51) Int. Cl.⁵: **C 30 B 7/00**, C 30 B 29/16, C 01 F 17/00

(54) **Nouvelles compositions particulaires d'oxyde de terre rare, leur préparation et leur application.**

(30) Priorité: **22.01.86 FR 8600855**

(43) Date de publication de la demande:
**23.09.87 Bulletin 87/39**

(45) Mention de la délivrance du brevet:
**01.08.90 Bulletin 90/31**

(84) Etats contractants désignés:
**AT BE CH DE ES FR GB GR IT LI LU NL SE**

(56) Documents cités:
**EP-A-0 097 563**
**EP-A-0 153 227**

(73) Titulaire: **RHONE-POULENC CHIMIE**
**25, quai Paul Doumer**
**F-92408 Courbevoie Cédex (FR)**

(72) Inventeur: **Demazeau, Gérard**
**42, rue de Chouiney**
**F-33170 Gradignan (FR)**
Inventeur: **Martel, Olivier**
**62, rue Mozart**
**F-59760 Grande-Synthe (FR)**
Inventeur: **Devalette, Michel**
**13, rue de Cotor**
**F-33170 Gradignan (FR)**
Inventeur: **Verdon, Eric**
**292, rue de Véron**
**F-17400 St. Jean d'Angely (FR)**

(74) Mandataire: **Tonnellier, Jean-Claude et al**
**Cabinet Nony & Cie. 29, rue Cambacérès**
**F-75008 Paris (FR)**

Courier Press, Leamington Spa, England.

**Description**

La présente invention a pour objet de nouvelles compositions particulaires d'oxyde de terre rare, leur préparation et leur application.

On sait que l'obtention d'oxydes de haute pureté sous forme finement divisée constitue un objectif de recherché important dans des domaines techniques divers, en vue préparer par exemple des céramiques, des abrasifs, des supports de catalyseurs, etc.

On sait que les terres rares sont présentes dans de nombreux minerais et constituent des sous-produits de la préparation de divers métaux. Leur valorisation pose des problèmes techniques et économiques difficiles. En effet, les méthodes d'élaboration conventionnelles des particules d'oxyde font généralement appel soit à des techniques de précipitation, soit à des procédés de type sol-gel. Dans les techniques de précipitation, l'addition de l'agent précipitant conduit à une contamination et donc à une altération de la pureté de l'oxyde obtenu. Dans les techniques sol-gel, la durée d'élaboration est généralement longue et les produits de base utilisés sont onéreux.

En outre, les techniques de calcination qui constituent généralement l'étape finale d'obtention des oxydes apportent des risques supplémentaires de pollution par le milieu environnant et conduisent à l'obtention de particules dont les états de surface sont peu favorables pour certaines applications.

Dans le brevet US n° 3,098,708, on a décrit l'obtention de particules d'oxydes de thorium et d'uranium par un procédé hydrothermal consistant à chauffer une solution acid telle qu'une solution chlorhydrique ou sulfurique d'oxyde de ces métaux à une température de 170 à 250°C, sous une pression de 100 à 400 p.s.i. (soit environ $6,5.10^5$ à $2,6.10^6$ Pa). Dans ce brevet US, il est indiqué que ce procédé est intéressant notamment pour la raison que les terres rares éventuellement présentes ne précipitant pas lors de la mise en oeuvre de ce procédé hydrothermal.

Le document EP—A—0153227 décrit la préparation de particules d'oxyde cérique par un procédé consistant principalement à hydrolyser une solution aqueuse d'un sel de cérium IV en milieu acide, à filtrer le précipité formé, puis à calciner les hydrates d'oxyde cérique obtenus. Les particules d'oxyde cérique obtenu sont des agrégats, c'est-à-dire des particules polycristallines, et non des monocristaux.

On a maintenant découvert qu'il est possible d'obtenir de fines particules d'oxyde de terre rare sous la forme de microcristallites dont on peut régler à la fois le taille et la morphologie, par un procédé solvothermal consistant à porter le milieu solvant dans des conditions de température et de pression correspondant à la région hypercritique. Ce procédé a permis d'obtenir pour la première fois les oxydes de terre rare sous forme de fines particules ayant des dimensions de l'ordre du micron et ayant une bonne homogénéité de répartition en taille des grains. Ces particules ont une structure de monocristal et sont notamment exemptes de porosités internes.

En outre, on a découvert qu'il est possible, à l'aide d'additifs appropriés, d'orienter la réaction vers l'obtention de grains dont la morphologie peut varier en fonction de l'additif utilisé.

La présente invention a donc pour objet de nouvelles compositions particulaires d'oxyde de terre rare, caractérisées par le fait que les particules se présentent sous la forme de monocristaux de taille et de morphologie homogènes dont les dimensions sont inférieures on égales à 10 µm et supérieures à 0,05 µm environ, et qu'au moins 80% des particules ont des dimensions variant dans l'intervalle x±0,2 x, x étant la dimension moyenne des particules de la composition considérée, étant entendu que l'intervalle de variation ±0,2 x n'est pas inférieur à ±0,1 µm.

Cette dernière condition signifie donc que pour les compositions de particules de dimension moyenne inférieure ou égale à 0,5 µm, au moins 80% des particules ont des dimensions pouvant varier dans l'intervalle x±0,1 µm. Pour les compositions de particules de dimension moyenne supérieure ou égale à 2 µm environ, le procédé qui sera décrit ci-après permet d'obtenir des variations dans la gamme x±0,1 x pour au moins 80% des particules.

Grâce au procédé de l'invention, on peut régler la taille des particules et obtenir à volonté des compositions particulaires dont la dimension moyenne des particules est inférieure par exemple à 2,5 µm, ou inférieure ou égale à 1 µm, ou même inférieure ou égale à 0,5 µm.

Les particules des compositions de l'invention ont généralement des dimensions supérieures ou égales à 0,1 micromètre.

L'état microcristallin est caractérisé en ce que la périodicité d'empilement des atomes constituant le matériau, caractéristique de la structure de l'oxyde considéré, est continue au travers de la particule.

La qualité microcristalline peut être contrôlée d'une part par une méthode de diffraction X classique sur cristal (pour les plus gros), d'autre part par une technique de microscopie électronique à haute résolution (pour les plus petits).

Dans la présente demande, on entend par "terres rares" les lanthanides et l'yttrium.

Les compositions de l'invention sont notamment des compositions à base d'oxyde d'yttrium, de lanthane, de cérium, de praséodyme, de terbium, de gadolinium, de néodyme, d'ytterbium, d'europium, de lutécium, etc...

Parmi les oxydes particulaires selon l'invention, on citera notamment les oxydes $CeO_2$, $PrO_2$, $TbO_2$, $Nd_2O_3$, $Tb_2O_3$, $Y_2O_3$, etc...

Comme indiqué ci-dessus, le procédé de l'invention permet d'orienter la croissance des microcristaux pour obtenir des particules ayant des morphologies spécifiques.

Par exemple, dans le cas de $CeO_2$, on peut obtenir soit des particules ayant une forme quasi-sphérique qui peuvent être utilisées notamment dans la préparation de céramiques, soit des particules à arêtes vives ayant la forme de pseudooctaèdres qui peuvent être utilisées notamment pour la réalisation d'abrasifs ou de supports de catalyseurs.

L'invention a également pour objet un procédé de préparation des compositions particulaires telles que définies précédemment.

Ce procédé est principalement caractérisé par le fait que l'on utilise comme produit de départ une source de terre rare dans un milieu liquide ne réagissant pas avec les oxydes de terres rares dans les conditions de température et de pression utilisées, que l'on chauffe dans une enceinte close ladit produit de départ jusqu'à une température et une pression au moins égales respectivement à la température critique et à la pression critique dudit milieu, ou à une température et/ou une pression inférieure mais très proche des valeurs critiques, ladite source de terre rare étant capable de se transformer en oxyde à cette température, que l'on maintient ladite température pendant un temps suffisant, que l'on refroidit rapidement le mélange réactionnel à une température inférieure à 100°C, et le ramène à la pression atmosphérique, puis que l'on sépare les microcristallites obtenus du milieu liquide.

Le temps pendant lequel un maintient le milieu réactionnel à une température au moins voisins de la température critique est un temps suffisant pour obtenir des particules ayant les caractéristiques désirées. Ce temps peut être déterminé dans chaque cas par de simples expériences de routine, et dépend notamment de la température choisie. Il varie généralement de 10 minutes à 1 heure environ.

La source de terre rare peut être tout dérivé de terre rare capable de se décomposer, ou de réagir avec le milieu liquide, pour former l'oxyde correspondant à la température réactionnelle. Comme source de terre rare, on citera en particulier des sels tels que des nitrates. On peut également utiliser d'autres sels minéraux tels que des chlorures en présence d'acide nitrique. On peut également utiliser comme source de terre rare, des sels organiques tels que des acétates ou des oxalates. Parmi les autres sources de terre rare, on citera par exemple les hydroxydes fraîchement précipités.

Le milieu liquide utilisé peut être tout liquide ne réagissant pas avec les oxydes de terre rare dans les conditions de température et de pression utilisées. Le milieu liquide doit dissoudre la source de terres rares, non pas nécessairement à la pression ambiante, mais au moins à la pression de la réaction. On sait en effet que la solubilité augmente avec la pression et, pour cette raison, il est possible d'utiliser comme produits de départ des suspensions de sels insolubles tels que des oxalates dont la dissolution à pression élevés est suffisante pour permettre la croissance de microcristallites à partir des germes cristallins d'oxyde formés.

Il faut remarquer en outre que l'utilisation de pressions élevées favorise la solubilisation du produit de départ, et favorise donc la formation d'un plus grand nombre de germes cristallins d'oxyde.

La concentration de la source de lanthanide est de préférence au moins égale à 1 mole/litre. La seule limits supérieure, pour la concentration, est la limite de solubilité de la source de lanthanide dans les conditions de température et de pression utilisées.

Parmi les liquides utilisables on citera notamment l'eau, les alcools inférieurs tels que le méthanol, l'éthanol, l'isopropanol, des dérivés carbonylés tels que l'acétone, des solutions d'anhydrides ou d'acides (par exemple des solutions de HCl, $SO_2$, $NO_3H$, $CH_3COOH$, etc...) et leurs mélanges. On opère généralement en milieu acide, notamment en milieu acide tamponné.

L'utilisation de divers milieux solvants ou de leurs mélanges permet de faire varier la température et la pression critiques.

Lorsque la terre rare possède plusieurs degrés d'oxydation possibles, l'addition d'agents oxydo-réducteurs, sous forme soluble dans le milieu, permet de favoriser, si désiré, l'obtention d'un oxyde particulier. Il faut remarquer à ce propos que dans le cas où la source de terre rare est un nitrate, l'ion nitrate se comporte comme oxydant. Par exemple, si l'on part du nitrate de cérium III, on obtiendra comme produit final l'oxyde de cérium IV ($CeO_2$) sans qu'il soit nécessaire d'ajouter un agent oxydant.

On opère généralement à température supérieure à 100°C, par exemple à des températures de 200 à 600°C, et à des pression généralement supérieures à 40 bar, par exemple des pressions de 50 à 2000 bar. On rappelle qu'un bar correspond à une pression de $10^5$ Pa.

L'augmentation de la température réactionnelle augmente la taille des cristallites d'oxyde, ainsi que leur cristallinité.

La vitesse de montée en température peut être variable et dépend de l'inertie thermique du système. Une montée en température relativement rapide favorise l'obtention d'une bonne homogénéité de taille des microcristallites. Par exemple, la vitesse de montée en température peut varier de 10°C à 50°C/minute.

On peut opérer par exemple en introduisant le produit de départ (solution ou suspension) dans une autoclave dont les parois ne réagissent pas avec le milieu liquide utilisé. On peut appliquer, si désiré, une pression initiale additionnelle qui s'ajoutera à la pression résultant du chauffage en milieu clos.

Pour la préparation de petites quantités, on peut également introduire le produit de départ dans une enceinte déformable capable de transmettre les variations de pression, et placer cette enceinte dans l'autoclave remplie d'un liquide qui transmettre à la fois la chaleur et la pression requises.

La durée du procédé n'excède généralement pas 30 minutes.

On a en outre découvert que l'addition d'espèces ioniques au produit de départ permet d'orienter la croissance cristalline et de maîtriser la morphologie des microcristallites d'oxyde de terre rare obtenus. Par exemple, dans le cas de l'oxyde de cérium, l'addition au produit de départ d'ions fluorure conduit à l'obtention de particules de forme sphéroïdale analogue à celles obtenues par décomposition des nitrates de Ce+IV en l'absence d'additifs anioniques. Par contre, l'addition d'ions tels que les ions carbonate ou hydrogénocarbonate, chlorure, acétate conduit à l'obtention de particules à arêtes vives de forme pseudo-octaédrique. Les espèces ioniques sont ajoutées en faibles quantités.

Les ions (anions, cations) modificateurs de la morphologie, peuvent être ajoutés sous la forme d'acides ou, de préférence, de sels correspondants. Les anions utilisés peuvent être tout anion qui ne donne pas avec la terre rare présente un sel plus insoluble que l'oxyde de cette terre rare. De préférence, les ions modificateurs sont ajoutés sous une forme soluble, et sont choisis tels qu'ils ne donnent pas de sel insoluble avec la terre rare considérée.

Les anions sont ajoutés par exemple sous la forme d'un sel alcalin ou alcalino-terreux. L'addition de tels sels ne provoque pas de contamination décelable des microcristallites obtenus. On retrouve la quasi-totalité de l'additif dans la solution, après séparation en fin de procédé des microcristallites. Les ions modificateurs sont ajoutés par exemple à raison de 1 à 10% en moles par rapport au nombre d'atomes de la terre rare. Les essais effectués n'ont pas fait ressortir de différences notables entre les effets obtenus avec la concentration la plus faible de 1% et le plus élevée de 10%.

L'invention a également pour objet l'utilisation des compositions particulaires d'oxyde de terres rares telles que définies ci-dessus, notamment dans la préparation de céramiques, d'agents abrasifs, de catalyseurs, de supports de catalyseurs, etc...

Les examples suivants illustrent l'invention sans toutefois la limiter.

Exemple 1

On introduit une solution aqueuse 1,8M de nitrate de cérium +IV dans un tube d'or que l'on scelle.

Le tube est placé dans une autoclave munie d'un dispositif permettant de faire varier la pression. L'autoclave est remplie d'eau utilisée comme transmetteur de la chaleur et de la pression. Le tube est soumis à une pression de 1 kilobar ($10^8$ Pa), à une température de 400°C pendant 30 minutes. La montée en température était de l'ordre de 20°C/minute. Après 30 minutes, un refroidit rapidement à 40°C de façon à effectuer une trempe. Après retour à la pression atmosphérique, on extrait le tube de l'enceinte et on constate que le mélange réactionnel contient une phase solide finement divisée. L'analyse de la phase solide par diffraction des rayons X montre qu'il s'agit de microcristallites exclusivement constitués de $CeO_2$. L'analyse par microscopie électronique à balayage montre que la taille moyenne des particules est de 0,3 µm avec une bonne homogénéité (supérieure à 80%) de répartition des tailles de particules entre 0,2 et 0,4 µm.

Exemple 2

On utilise comme produit de départ une solution aqueuse 1,8 M de nitrate de cérium+III que l'on soumet aux mêmes conditions opératoires qu'à l'exemple 1.

On obtient de fines particules constituées de $CeO_2$ sous la forme d'octaèdres.

La dimension moyenne des particules est de 0,2 µm.

L'étude des images obtenues par microscopie électronique à balayage montre que plus de 80% des particules ont une dimension comprise entre 0,1 et 0,3 µm.

Exemple 3

On ajoute à une solution aqueuse 1,8 M de nitrate de cérium+IV, 5% en moles de NaF par rapport au nombre de moles de cérium. Cette solution est traitée comme décrit à l'exemple 1. On obtient des grains de forme isotrope. L'étude des clichés de microscopie électronique à balayage montre une grande homogénéité de taille (entre 0,1 et 0,3 µm) et de forme des grains. La dimension moyenne des particules est égale à 0,2 µm environ.

Exemple 4

On utilise comme produit de départ la solution de l'exemple 1, mais on ajoute en outre du carbonate de sodium à raison de 5% en moles par rapport au nombre de moles de cérium. Les conditions opératoires sont celles décrites à l'exemple 1.

On obtient des microcristallites de $CeO_2$ ayant la forme de pseudooctaèdres à arêtes vives et ayant une dimension moyenne de 2 µm, avec plus de 80% des particules ayant des dimensions comprises entre 1,8 et 2,2 µm.

Exemple 5

En partant de la solution de l'exemple 1, mais en ajoutant à cette solution 5% en moles de chlorure de sodium (par rapport au nombre de moles de cérium) on obtient, dans les mêmes conditions expérimentales qu'à l'exemple 1, des cristallites de $CeO_2$ de forme octaédrique ayant des dimensions moyennes de 1,5 µm, avec plus de 80% des particules ayant des dimensions comprises entre 1,2 et 1,8 µm.

Exemple 6

On utilise comme produit de départ la même solution qu'à l'exemple 1, mais on ajoute 5% en moles d'acétate de sodium. Après traitement comme décrit à l'exemple 1, on obtient des microcristallites à arêtes vives de taille homogène (plus de 80% des particules ont des tailles comprises entre 1,2 et 1,8 µm); dimension moyenne des particules: 1,5 µm.

Exemple 7

On utilise comme produit de départ une solution analogue à celle de l'exemple 1, mais on ajoute en outre 5% en moles d'hydrogénocarbonate de sodium.

On obtient des microcristallites de CeO₂ sous la forme d'octaèdres de taille homogène (0,2—0,4 µm pour plus de 80% des particules); taille moyenne: 0,3 µm.

**Revendications**

1. Compositions particulaires d'oxyde de terre rare, la dite terre rare étant choisie parmi les lathanides et l'yttrium caractérisées par le fait que les particules se présentent sous la forme de monocristaux de taille et de morphologie homogènes dont les dimensions sont inférieures ou égales à 10 µm et supérieures à 0,05 µm environ, et qu'au moins 80% des particules ont des dimensions variant dans l'intervalle x±0,2 x, x étant la dimension moyenne des particules de la composition considérée, étant entendu que l'intervalle de variation ±0,2 x n'est pas inférieur à ±0,1 µm.

2. Compositions selon la revendication 1, caractérisées par le fait que les particules ont une dimension moyenne supérieure ou égale à 2 µm, et qu'au moins 80% des particules ont des dimensions variant dans l'intervalle x±0,1 x.

3. Compositions selon la revendication 1 ou 2, caractérisées par le fait que l'oxyde de terre rare est choisi parmi les oxydes d'yttrium, de lanthane, de cérium, de praséodyme, de terbium, de gadolinium, de néodyme, d'ytterbium ou d'europium.

4. Compositions selon la revendication 3, caractérisées par le fait que l'oxyde de terre rare est CeO₂.

5. Compositions selon la revendication 4, caractérisées par le fait que lesdites particules ont une forme isotrope ou octaédrique.

6. Procédé de préparation des compositions telles que définies dans l'une quelconques des revendications 1 à 5, caractérisé par le fait que l'on utilise comme produit de départ une source de terre rare dans un milieu liquide ne réagissant pas avec les oxydes de terres rares dans les conditions de température et de pression utilisées, que l'on chauffe dans une enceinte close ledit produit de départ jusqu'à une température et une pression au moins égales respectivement à la température critique et à la pression critique dudit milieu, ou à une température et/ou une pression inférieure mais très proche des valeurs critiques, ladite source de terre rare étant capable de se transformer en oxyde à cette température, que l'on maintient ladite température pendant un temps suffisant, que l'on refroidit rapidement le mélange réactionnel à une température inférieure à 100°C, et le ramène à la pression atmosphérique, puis que l'on sépare les microcristallites obtenus du milieu liquide.

7. Procédé selon la revendication 6, caractérisé par le fait que la source de terre rare est choisie parmi les nitrates, d'autres sels minéraux en présence d'acide nitrique, des sels organiques et des hydroxydes.

8. Procédé selon la revendication 6 ou 7, caractérisé par le fait que le chauffage est effectué avec une vitesse de montée en température de 10 à 50°C per minute.

9. Procédé selon la revendication 6, 7 ou 8, caractérisé par le fait que le milieu liquide est choisi parmi l'eau, les alcanols inférieurs, les dérivés carbonylés, les solutions d'anhydrides ou d'acides, et leurs mélanges.

10. Procédé selon l'une quelconque des revendications 6 à 9, caractérisé par le fait que l'on opère à des températures de 200 à 600°C, et à des pressions supérieures à 40 bar (4.10⁶ Pa).

11. Procédé selon l'une quelconque des revendications 6 à 10, caractérisé par le fait que, pour favoriser l'obtention d'une morphologie particulière des particules, on ajoute au produit de départ des espèces ioniques.

12. Procédé selon la revendication 11, caractérisé par le fait que l'on ajoute lesdites espèces ioniques sous la forme d'acides ou de sels, à raison de 1 à 10% en moles par rapport au nombre d'atomes de terre rare.

13. Procédé selon la revendication 11 ou 12, caractérisé par le fait que l'on ajoute les ions modificateurs sous la forme de sels alcalins ou alcalino-terreux.

14. Procédé selon l'une quelconque des revendications 11 à 13, caractérisé par le fait que les ions modificateurs sont choisis parmi les fluorures, les chlorures, les carbonates, les hydrogénocarbonates et les acétates.

15. Procédé selon l'une quelconque des revendications 6 à 14, caractérisé par le fait que le temps pendant lequel on maintient le mélange réactionnel à une température au moins voisine de la température critique varie de 10 mintues à 1 heure environ.

16. Utilisation des compositions selon l'une quelconque des revendications 1 à 5, dans la préparation de céramiques, d'agents abrasifs, de catalyseurs ou de supporte de catalyseurs.

**Patentansprüche**

1. Teilchenförmige Seltenerdmetalloxid-Zusammensetzungen, in denen das Seltenerdmetall unter Lantaniden und Yttrium gewählt ist, dadurch gekennzeichnet, daß die Teilchen in Form von Einkristallen mit homogener Größe und Morphologie vorliegen, deren Abmessungen unter oder gleich etwa 10 µm und über etwa 0,05 µm sind, mindestens 80% der Teilchen Abmessungen haben, die im Bereich von x±0,2 x variieren, wobei x die mittlere Größe der Teilchen der Zusammensetzung ist und der Variationsbereich ±0,2 x nicht unter ±0,1 µm liegt.

2. Zusammensetzungen nach Anspruch 1, dadurch gekennzeichnet, daß die Teilchen eine mittlere Größe über oder gleich 2 µm haben und mindestens 80% der Teilchen Größen haben, die im Bereich x±0,1 x variieren.

3. Zusammensetzungen nach Anspruch 1 oder 2, dadurch gekennzeichnet, daß das Seltenerdmetalloxid unter Oxiden von Yttrium, Lanthan, Cer, Praseodym, Terbium, Gadolinium, Neodym, Ytterbium oder Europium gewählt ist.

4. Zusammensetzungen nach Anspruch 3, dadurch gekennzeichnet, daß das Seltenerdmetalloxid $CeO_2$ ist.

5. Zusammensetzungen nach Anspruch 4, dadurch gekennzeichnet, daß die Teilchen eine isotrope oder oktaedrische Form haben.

6. Verfahren zur Herstellung der Zusammensetzungen nach einem der Ansprüche 1 bis 5, gekennzeichnet durch

Verwendung einer Quelle an Seltenerdmetallen in einem flüssigen Medium, das mit den Seltenerdmetalloxiden unter den angewandten Temperatur- und Druckbedingungen nicht reagiert, als Ausgangsprodukt,

Erhitzen des Ausgangsprodukts in einem geschlossenen Behälter bis zu einer Temperatur und einem Druck, die zumindest der kritischen Temperatur und dem kritischen Druck des Mediums gleich sind, oder auf niedrigere, jedoch den kritischen Werten sehr nahe Temperatur und/ oder Druck, wobei die Quelle an Seltenerdmetallen bei dieser Temperatur in ein Oxid umgewandelt werden kann,

Aufrechterhalten dieser Temperatur während genügend langer Zeit,

schnelles Abkühlen des Reaktionsgemisches auf eine Temperatur unter 100°C und Zurückbringen auf atmosphärischem Druck und Abtrennen der erhaltenen Einkristallite aus dem flüssigen Medium.

7. Verfahren nach Anspruch 6, dadurch gekennzeichnet, daß die Quelle an Seltenerdmetallen unter Nitraten, anderen anorganischen Salzen in Gegenwart von Salpetersäure, organischen Salzen und Hydroxiden gewählt wird.

8. Verfahren nach Anspruch 6 oder 7, dadurch gekennzeichnet, daß das Erhitzen mit einer Temperaturanstiegsgeschwindigkeit von 1 bis 50°C je Minute durchgeführt wird.

9. Verfahren nach Anspruch 6, 7 oder 8, dadurch gekennzeichnet, daß das flüssige Medium unter Wasser, niedrigen Alkanolen, Carbonylderivaten, Lösungen von Anhydriden oder Säuren und ihren Gemischen gewählt wird.

10. Verfahren nach einem der Ansprüche 6 bis 9, dadurch gekennzeichnet, daß die Reaktion bei Temperaturen von 200 bis 600°C und Drücken über 40 bar ($4.10^6$ Pa) durchgeführt wird.

11. Verfahren nach einem der Ansprüche 6 bis 10, dadurch gekennzeichnet, daß zur Begünstigung einer besonderen Morphologie der Teilchen dem Ausgangsprodukt Ionen zugesetzt werden.

12. Verfahren nach Anspruch 11, dadurch gekennzeichnet, daß die Ionen in Form von Säuren oder Salzen in einer Menge von 1 bis 10 Molprozent, bezogen auf die Atomanzahl an Seltenerdmetall, zugesetzt werden.

13. Verfahren nach Anspruch 11 oder 12, dadurch gekennzeichnet, daß die modifizierenden Ionen in Form von Alkali- oder Erdalkalimetallsalzen zugesetzt werden.

14. Verfahren nach einem der Ansprüche 11 bis 13, dadurch gekennzeichnet, daß die modifizierenden Ionen unter Fluoriden, Chloriden, Carbonaten, Hydrogencarbonaten und Acetaten gewählt werden.

15. Verfahren nach einem der Ansprüche 6 bis 14, dadurch gekennzeichnet, daß die Zeit, während der das Reaktionsgemisch bei einer der kritischen Temperatur zumindest nahen Temperatur gehalten wird, von etwa 10 Minuten bis 1 Stunde variiert wird.

16. Verwendung der Zusammensetzungen nach einem der Ansprüche 1 bis 5 zur Herstellung von Keramik, Abriebstoffen, Katalysatoren oder Träger für Katalysatoren.

**Claims**

1. Particulate compositions of rare earth oxide, the said rare earth being chosen from the lanthanides and yttrium, characterized by the fact that the particles appear in the form of monocrystals of homogeneous size and morphology, the dimensions of which are less than or equal to 10 µm and greater than about 0.05 µm, and that at least 80% of the particles have dimensions varying within the range x±0,2 x, x being the mean dimension of the particles of the composition in question, it being understood that the range of variation ±0,2 x is not less than ±0,1 µm.

2. Compositions as in Claim 1, characterized by the fact that the particles have a mean dimension greater than or equal to 2 µm, and that at least 80% of the particles have dimensions varying within the range x±0,1 x.

3. Compositions as in Claim 1 or 2, characterized by the fact that the rare earth oxide is chosen from the oxides or yttrium, lanthanum, cerium, praseodymium, terbium, gadolinium, neodymium, ytterbium or europium.

4. Compositions as in Claim 3, characterized by the fact that the rare earth oxide is $CeO_2$.

5. Compositions as in Claim 4, characterized by the fact that the said particles have an isotropic or octahedral shape.

6. A method of preparation of the compositions as defined in any one of the Claims 1 to 5, characterized by the fact that the starting product employed is a source of rare earth in a liquid medium which does not react with the rare earth oxides under the conditions of temperature and pressure employed, that the said starting product is heated in a closed container up to a temperature and pressure at least equal respectively to the critical temperature and critical pressure of the said medium or to a temperature and/or pressure less than but very close to the critical values, the said source of rare earth being capable of being transformed into oxide at this temperature, that the said temperature is maintained for a sufficient time, that the reaction mixture is cooled rapidly to a temperature lower than 100°C and brought back to atmospheric pressure, and then the microcrystallites obtained are separated from the liquid medium.

7. A method as in Claim 6, characterized by the fact that the source of rare earth is chosen from the nitrates, other mineral salts in the presence of nitric acid, organic salts and hydroxides.

8. A method as in Claim 6 or 7, characterized by the fact that the heating is carried out at a rate of rise in temperature of from 1 to 50°C per minute.

9. A method as in Claim 6, 7 or 8, characterized by the fact that the liquid medium is chosen from water, the lower alkanols, the carbonyl derivatives, solutions of anhydrides or acids, and mixtures of these.

10. A method as in any one of the Claims 6 to 9, characterized by the fact that it is performed at temperatures from 200 to 600°C and at pressures higher than 40 bar ($4.10^6$ Pa).

11. A method as in any one of the Claims 6 to 10, characterized by the fact that in order to favour the obtaining of a particular morphology of the particles, ionic species are added to the starting product.

12. A method as in Claim 11, characterized by the fact that the said ionic species are added in the form of acids or salts at the rate of 1 to 10% in moles with respect to the number of atoms of rare earth.

13. A method as in Claim 11 or 12, characterized by the fact that the modifier ions are added in the form of alkaline or alkalin-earth salts.

14. A method as in any one of the Claims 11 to 13, characterized by the fact that the modifier ions are chosen from the fluorides, chlorides, carbonates, bicarbonates and acetates.

15. A method as in any one of the Claims 6 to 14, characterized by the fact that the time during which the reactive mixture is held at a temperature at least close to the critical temperature varies from about 10 minutes to 1 hour.

16. Utilization of the compositions as in any one of the Claims 1 to 5 in the preparation of ceramics, abrasives, catalysts or supports for catalysts.